# FASCICULE DE BREVET EUROPEEN

(11) **EP 1 022 575 B1**
(45) Date de publication et mention de la délivrance du brevet: **06.10.2004**
(21) Numéro de dépôt: 00400162.4
(22) Date de dépôt: 21.01.2000
(51) Int. Cl.: G01R 31/36

(54) **Dispositif de mesure de la consommation électrique d'un terminal portable de traitement de données ou de signaux**
Elektrische Verbrauchsmessungsanordnung für einen tragbaren Terminal zur Verarbeitung von Daten oder Signalen
Apparatus for the measurement of electrical consumption of a portable terminal processing data or signals

(30) Priorité: 22.01.1999 FR 9900697
(43) Date de publication de la demande: 26.07.2000
(73) Titulaire: SAGEM SA, 75116 Paris (FR)
(72) Inventeur: Bernard, Robert, 78700 Conflans Sainte Honorine (FR)
(74) Mandataire: Bloch, Gérard

(56) Documents cités:
- EP-A- 0 792 001
- US-A- 5 856 757

## Description

Un terminal portable, de traitement de données ou de signaux, comporte une batterie qu'il faut recharger périodiquement à partir du secteur, ou une pile, qu'il faut changer. Si l'on considère par exemple un combiné de radiotéléphonie cellulaire, il consomme de l'énergie électrique même lorsqu'il est en veille mais inutilisé, car il doit rester partiellement alimenté pour être localisé par les stations du réseau radio. De ce fait, la batterie présente une autonomie limitée.

L'utilisateur du combiné doit donc trouver un compromis entre des mises en recharge rapprochées, fastidieuses et pas toujours nécessaires ni même satisfaisantes au plan électrique, et le risque de déconnexion par manque d'énergie alors que son combiné n'a pas été rechargé depuis longtemps.

Pour obtenir une mesure de la consommation, et ainsi avertir l'utilisateur d'un besoin de recharge, comme le courant consommé à partir de la batterie est très variable, on pourrait songer à échantillonner la mesure d'un capteur de courant à un rythme suffisamment élevé pour en reconstituer la forme et ensuite effectuer un filtrage numérique pour lisser le signal et obtenir cette mesure de consommation. Cependant, une telle solution serait complexe.

Le document EP-A-0 792 001 décrit un chargeur de batterie qui fournit une valeur de l'état de charge de la batterie.

La présente invention vise à mesurer, de façon plus simple, le courant consommé par les circuits d'un terminal portable.

A cet effet, l'invention concerne tout d'abord un dispositif de mesure du courant échangé entre une source de stockage d'énergie et des circuits électriques d'un terminal portable de traitement de données ou de signaux, comportant un capteur de mesure de courant destiné à être relié entre la source et lesdits circuits, caractérisé par le fait que le capteur est relié à une première entrée de premiers moyens intégrateurs, agencés pour intégrer la mesure du courant et pour commander en conséquence des moyens comparateurs agencés pour détecter le franchissement d'un seuil haut par l'intégrale du courant et pour alors appliquer, à une deuxième entrée des premiers moyens intégrateurs, un signal de rétroaction calibré, de rappel en dessous du seuil haut, et il est prévu des deuxièmes moyens intégrateurs, d'intégration des signaux de rétroaction, pour fournir une mesure du courant échangé.

Ainsi, les premiers moyens intégrateurs intègrent le courant et effectuent par là-même un filtrage passe-bas de celui-ci, donc en s'affranchissant des valeurs instantanées qu'il peut prendre. Ils peuvent avoir une grande sensibilité puisque la rétroaction limite la dynamique de fonctionnement à la valeur de seuil haut. En d'autres termes, les moyens comparateurs réduisent l'intégrale du courant et les deuxièmes moyens intégrateurs effectuent le cumul des réductions, qui représente la mesure recherchée, c'est-à-dire l'intégrale véritable (sans rétroaction) du courant depuis le début de la mesure.

L'invention concerne aussi un terminal portable de traitement de données ou de signaux, caractérisé par le fait qu'il comporte un dispositif selon l'invention.

L'invention sera mieux comprise à l'aide la description suivante d'une forme de réalisation préférée d'un terrminal comportant le dispositif de mesure de l'invention, et d'une variante, en référence au dessin annexé, sur lequel :
- la figure 1 est un schéma électrique par blocs d'un combiné de radio téléphonie comportant le dispositif de mesure, relié à la batterie du combiné,
- la figure 2 est un schéma électrique détaillée de la forme de réalisation préférée du dispositif,
- la figure 3 est un schéma électrique détaillée de la forme de réalisation de la variante, reprenant les éléments de la figure 2,
- la figure 4, formée des figures 4A et 4B, est un diagramme temporel illustrant les variations du courant mesuré et sa mesure,
- la figure 5 est un schéma électrique détaillé d'un circuit de rétroaction calibrée, et
- la figure 6 est un datagramme temporel relatif au circuit de rétroaction de la figure 5.

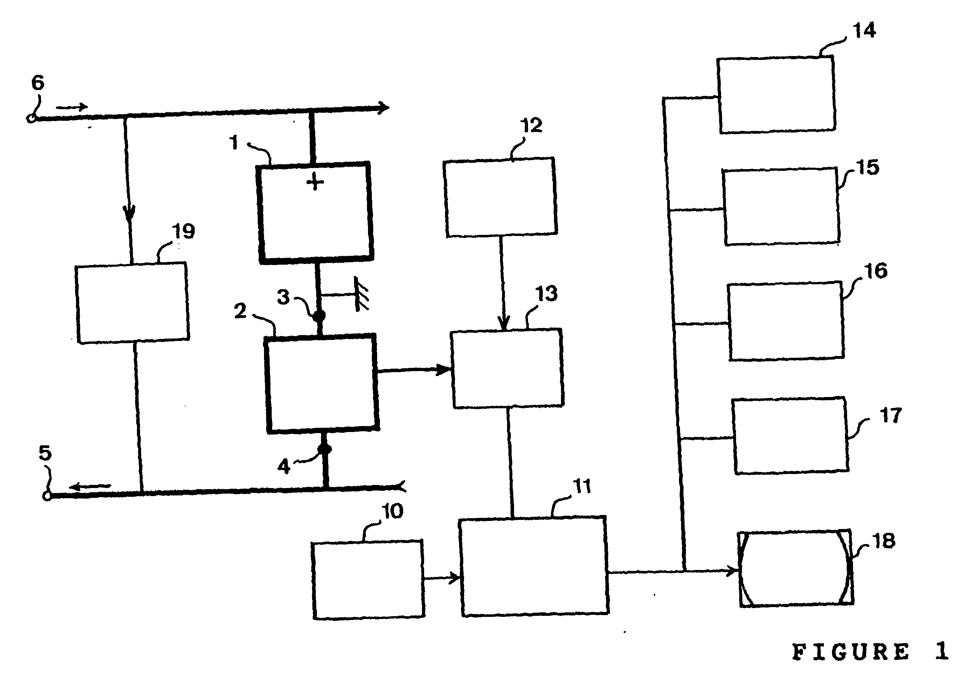

Le dispositif de mesure de courant représenté sur la figure 1 comporte un circuit capteur 2, interposé en série, à travers des bornes 3, 4, entre une borne, ici de masse, d'une batterie 1 et les bornes de masse électrique des divers circuits électroniques représentés. La référence 19 désigne les circuits, radio et autres, externes au dispositif, c'est-à-dire qui n'interviennent que par leur consommation pour traiter des données, numériques, ou des signaux, comme par exemple des signaux vocaux, analogiques. La borne 4 est reliée aux bornes de masse ci-dessus ainsi qu'à une borne 5 d'un connecteur de rechargement de la batterie 1 par un chargeur externe, une borne 6 de ce connecteur étant reliée à la borne positive de la batterie 1, qui alimente directement les circuits ci-dessus. Par convention, et dans un but de clarté pour la suite de l'exposé, la borne négative de la batterie 1, reliée à la borne 3, fournit la référence théorique de masse. Les flèches à côté des traits dans la zone des circuits ci-dessus représentent le sens du courant de charge, lorsqu'il est présent, et les flèches intégrées aux traits représentent le courant de décharge.

On comprendra que le dispositif de mesure de courant aurait pu, au contraire, être monté en série avec la borne positive de la batterie 1.

Le circuit capteur 2 est relié, par une sortie de mesure, à un bloc numérique 13 de comptage d'impulsions commandé par un bloc logique 12 indiquant l'état de fonctionnement du combiné. Le bloc de comptage 13 est relié en sortie à une mémoire 14 mémorisant le résultat de chaque comptage. Dans cet exemple, il est en outre prévu une pluralité de mémoires, ici trois mémoires 15, 16, 17, dans lesquelles sont mémorisés les résultats ou cumuls partiels de comptage, relatifs chacun à un état particulier de fonctionnement du combiné, comme l'émission, la réception, la veille, selon les indications du bloc logique 12. La mémoire 14 contient la somme de ces cumuls partiels. Elle peut être prévue solidaire de la batterie 1. Il peut même être prévu que le shunt 21, le premier intégrateur 22-27 et par exemple l'ensemble comparateur 28, 29 soient montés sur la batterie 1.

Une base de temps 10 rythme le fonctionnement d'un microprocesseur 11 relié à l'ensemble des circuits et les gérant, et en particulier à un écran 18 d'affichage de la consommation de courant. Plus précisément ici, connaissant les caractéristiques de la batterie 1, on affiche la charge restante, par exemple sous la forme d'une durée d'autonomie en veille et/ou d'une durée d'activation, en communication.

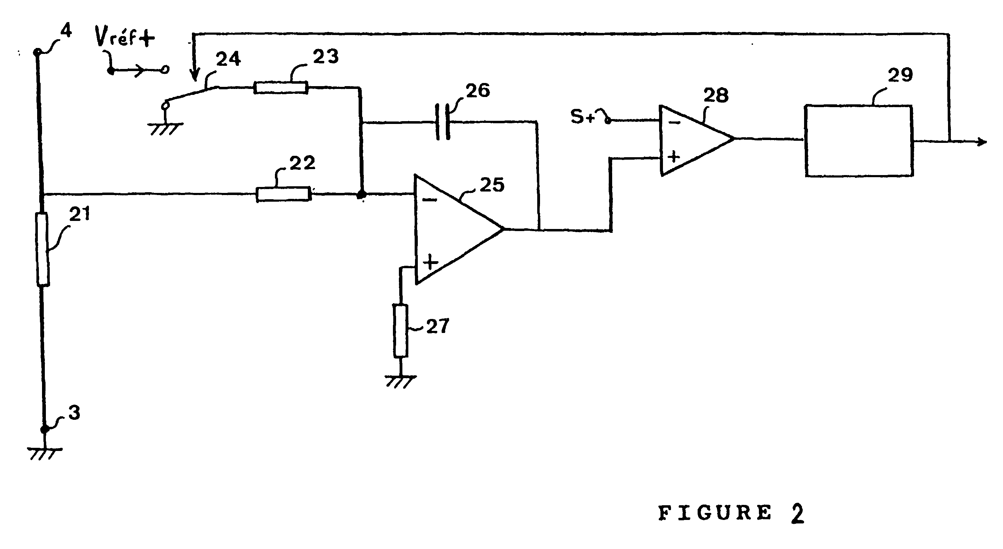

Le circuit capteur 2 est détaillé sur la figure 2. Il comporte un élément 21 capteur de courant, ici un shunt de mesure de courant sous la forme d'une résistance de précision, de faible valeur. La consommation à mesurer ne dépasse pas ici 5 milliampères, si bien qu'une résistance 21 de 20 ohms ne produit au maximum que 0,1 volt de chute du potentiel appliqué aux bornes des circuits 19, correspondant à une remontée de leur potentiel de masse, qui fluctuera donc légèrement, ce qui est acceptable.

Comme indiqué, la borne 3 est à la masse (borne négative de la batterie 1) et la borne 4 présente le faible potentiel ci-dessus représentant le courant traversant la batterie 1. Ce potentiel est positif lorsqu'il s'agit d'un retour à la masse d'un courant de décharge et est négatif quand on charge la batterie 1 par le connecteur 5-6. La borne 4 est reliée à une extrémité d'une première entrée d'un montage intégrateur constituée par une résistance série 22 de précision, de forte valeur devant celle de la résistance 21, reliée par son autre extrémité à une entrée inverseuse d'un amplificateur opérationnel 25 dont l'autre entrée, non inverseuse, est polarisée à la masse à travers une résistance 27. Un condensateur 26 relie la sortie de l'amplificateur 25 à son entrée inverseuse et permet ainsi un fonctionnement en intégrateur, intégrant le signal de tension aux bornes du shunt 21, qui représente le courant de la batterie 1, et en particulier permettant de s'affranchir de tout problème de mesure par échantillonnage du courant instantané.

Le montage intégrateur ci-dessus comporte une deuxième entrée constituée par une résistance de précision 23 dont une extrémité est reliée à l'entrée inverseuse de l'amplificateur 25 et dont d'autre extrémité, d'entrée, est alimentée par une tension continue de référence Vréf+ à travers un interrupteur commandé 24. Ce dernier est constitué ici d'une porte analogique telle qu'un transistor ou circuit intégré équivalent, à commande logique.

La sortie de l'ensemble 22-27, intégrant le signal de la borne 4 représentant le courant de décharge de la batterie 1, commande un circuit comparateur à seuil haut 28, 29 commandant un second intégrateur 12-17.

D'une façon générale, le comparateur 28, 29 lit le signal de sortie du premier intégrateur 22-27 et produit en réponse un signal de contre-réaction commandant l'interrupteur 24 de façon à appliquer, à la seconde entrée 23 du premier intégrateur 22-27, un signal calibré tendant à ramener la sortie de celui-ci sous le seuil. Comme le signal est calibré, l'excursion de tension lors du rappel a toujours une valeur fixe, correspondant à une variation de charge électrique parfaitement déterminée dans le condensateur 26, ce qui, partant d'une tension de seuil haut Vs+, ramène, vers une position de repos, par exemple deux volts. On limite ainsi, à l'intérieur d'une plage compatible avec la tension d'alimentation, ici entre la masse et 12 volts, la dynamique de fonctionnement de la sortie de l'intégrateur 22-27. Sinon, en l'absence de rétroaction, la sortie de l' intégrateur 22-27 croîtrait indéfiniment lors de la décharge batterie et cet intégrateur 22-27 devrait alors être prévu avec une sensibilité réduite, pour présenter une excursion ne dépassant pas une dizaine de volts lors d'une décharge complète de la batterie 1.

Dans le présent montage, au contraire, on compense par rétroaction la variation de la tension en sortie de l'intégrateur 22-27 et, afin cependant de ne pas perdre l'information correspondante relative à l'intégrale du courant batterie en fonction du temps t, on intègre, et mémorise donc, la "quantité" de rétroaction qui a été appliquée au premier intégrateur 22-27.

Les circuits comparateurs 28, 29 et intégrateurs 12-17 vont être expliqués plus en détails.

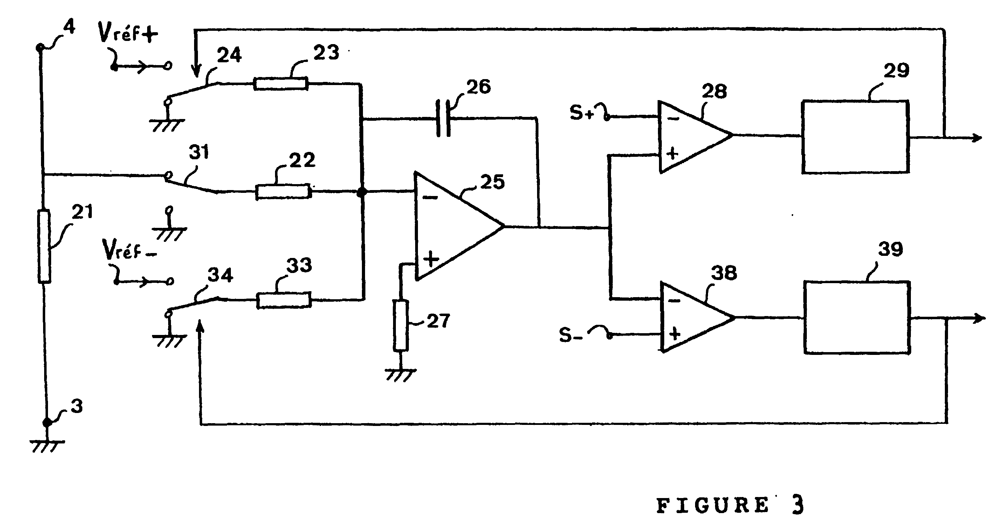

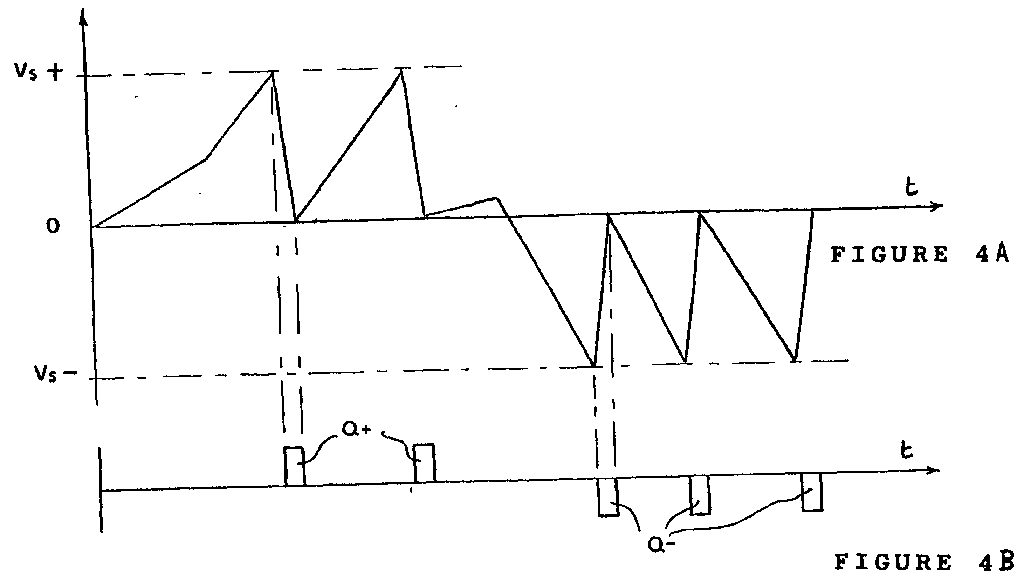

La rétroaction ci-dessus, effectuée de façon discontinue dans cet exemple, consiste à réinjecter, dans la capacité 26, une quantité prédéterminée de charges électriques lorsque sa tension en sortie dépasse la tension de seuil haut Vs +, ici fixée par exemple à 8 volts (fig. 4A). Les figures 4A et 4B, sur lesquelles le temps t est porté en abscisse, traitent le cas général de la variante de réalisation de la figure 3, qui, en plus du montage de la figure 2, traite aussi les courants dits négatifs, c'est-à-dire de recharge de la batterie 1. On ne s 'intéressera ici tout d'abord, pour expliquer la figure 2, qu'au courant de décharge et au seuil haut Vs +.

Un comparateur 28, constitué d'un amplificateur opérationnel, reçoit à cet effet la sortie de l'amplificateur d'intégration 25 et la compare à la tension de seuil haut Vs +, pour commander un circuit monostable 29 lorsque la sortie de l'amplificateur intégrateur 25 dépasse le seuil Vs +. Le circuit monostable 29 produit alors une impulsion Q+ (fig. 4B), de durée calibrée K, qui ferme l'interrupteur 24 et provoque donc un transfert, au condensateur 26, d'une quantité de charges électroniques qui est fixée par la valeur de la tension de référence Vréf+ et la durée K.

Le dispositif fonctionne correctement dans une gamme très large de mesure de courants de forme quelconque, puisque la valeur du courant mesuré n'influe que sur la vitesse d'évolution de la sortie de l'intégrateur 22-27, cette dernière restant, dans tous les cas, limitée par le seuil haut Vs+.

Le monostable 29 pourrait être de type analogique, avec une alimentation filtrée et bien stabilisée, afin de limiter toute dérive de la durée K. Dans cet exemple, le monostable 29 est numérique et comporte un compteur recevant un signal d'horloge de la base de temps 10 à travers une porte ET contrôlée par le comparateur 28 dont la sortie passe à l'état logique 1 pour activer le monostable 29.

La tension de référence Vréf+ est inférieure à la tension de repos, c'est-à-dire inférieure à 2 volts dans cet exemple, si l'on veut effectivement revenir à cette tension de repos. Elle peut être éventuellement choisie négative ou encore être simplement la tension de masse. Si l'on veut limiter la durée K de contre-réaction par rapport au cycle, variable, des activations du monostable 29, on peut prévoir une valeur de résistance 23 plus faible que celle de la résistance 22. On aurait pu de même prévoir une tension de repos de l'intégrateur 22-27 plus élevée, par exemple 6 volts, le monostable 29 étant alors (à tension de seuil Vs + inchangée) déclenché plus souvent, pour injecter à chaque fois, dans le condensateur 26, un quantum réduit de charges.

On notera que, pour rester sous le seuil Vs+, il n'est pas obligatoire que la charge de rétroaction corresponde exactement à la différence de tension entre la tension de repos et la tension de seuil Vs +. Cette charge peut parfaitement être surdimensionnée pour ramener la tension de sortie de l'amplificateur 25 à un niveau inférieur à la tension de repos, dans la mesure où ce niveau est compatible avec la plage de fonctionnement correct du montage. Elle pourrait au contraire être sous-dimensionnée, c'est-à-dire ramener à la descente, éventuellement en plusieurs fois, la tension intégrée de sortie vers la position de repos, mais sans l'atteindre, c'est-à-dire ramener simplement la tension intégrée sous le seuil Vs +. En pareil cas, le monostable 29 serait déclenché plus souvent.

De ce fait, on conçoit que le montage à fonctionnement cyclique présenté ici, à cycle variable en fonction du courant mesuré, équivaut à un montage à fonctionnement statique, dans lequel la variable de mesure ne serait plus le nombre d'injections de quantités calibrées de charges mais serait l'amplitude, variable, d'un signal permanent de commande d'un atténuateur réglable remplaçant l' interrupteur 24, pour asservir la tension de sortie de l'intégrateur 22-27 à une valeur de consigne, ou repos.

On remarquera en outre que l'intégrateur 22-27 aurait pu avoir été prévu pour inverser le sens du courant intégré. Les explications précédentes resteraient valables, l'échelle des tensions 0 à 12 volts étant alors à retourner. De même, l'interrupteur 24 associé à la tension Vs+ ne constitue qu'un étage calibré de haute précision, qui améliore la précision de la mesure. Sinon, la sortie du monostable 28 pourrait directement alimenter la résistance 23, à travers ici un inverseur fournissant une impulsion descendante, de tirage à la masse par exemple.

Chaque impulsion Q + de rétroaction du monostable 29 est comptée dans le circuit 13, c'est-à-dire additionnée, ou intégrée, au résultat de comptage précédent pour fournir une valeur intégrale à jour, ici numérique, représentant l'intégralité de la rétroaction depuis le début de la mesure c'est-à-dire le nombre N1 de fois que l'on a abaissé, d'une valeur prédéterminée (Vs+ - V repos), la tension de l'amplificateur 25. Cette valeur intégrale (N fois 4 volts ici) de la contre-réaction représente donc aussi la valeur, fictive, que présenterait en plus la tension actuelle de l'intégrateur 22-27 si elle n'avait pas subi de contre-réaction. Cette valeur intégrale de la contre-réaction peut être mémorisée, de préférence comme ici, sous forme numérique. La mémoire 14 reçoit, du circuit 13, le nombre N1 d'impulsions Q + du monostable ou temporisateur 29. Dans cet exemple, le dispositif fournit en fait des informations plus détaillées par le fait que, en plus, le circuit 12 indique, au circuit de comptage 13, l'état de fonctionnement du combiné. Le circuit de comptage 13 affecte alors l'impulsion Q+ du monostable 29 qu'il vient de recevoir à un sous-total de l'une des mémoires 15 à 17, correspondant à un état de fonctionnement du combiné. A chaque fois, le circuit 13 relit la mémoire 14 et celle des mémoires 15 à 17 qui est concernée et ajoute une unité au nombre qu'elle contenait. Un clavier, non représenté, permet à l'utilisateur du combiné de commander l'unité centrale 11 pour consulter les mémoires 14-17 au moyen de l'écran 18.

L'unité centrale 11 divise le nombre N1 lu en mémoire 14-17 par un nombre fixe M en mémoire morte qui représente le maximum possible, c 'est-à-dire l'intégrale du courant de décharge complète de la batterie 1, donc sa capacité en ampères-heure. Le quotient obtenu N/M est affiché sous la forme d'un pourcentage de décharge ou bien le microprocesseur 11 en calcule le complément à 1 pour afficher un pourcentage de capacité batterie restante 100 [1 - N1/M], affiché comme tel ou bien encore sous forme de durées d'autonomie restante pour la veille et/ou pour la communication.

Comme indiqué, le schéma de la figure 3 reprend les éléments de la figure 2, avec les mêmes références respectives et les même fonctions, et traite en plus des tensions d'entrée négatives, c'est-à-dire mesure aussi le courant de recharge de la batterie 1 par les bornes 5-6. De façon globale, les fonctions des circuits de la figure 2 sont dupliquées pour former deux chaînes de mesure parallèles dont les mesures sont soustraites pour fournir une mesure de bilan de consommation. Ici, l'intégrateur 22-27 n'est pas dupliqué car il est exploité par les deux chaînes, en intégration du courant dans un sens et dans l'autre. Les circuits logiques 12-17 sont de même partagés par les deux chaînes de mesure.

A cette fin, un second circuit comparateur 38, 39 de rétroaction comporte un comparateur 38 et un circuit monostable 39 homologues respectifs des circuits 28 et 29 et dont la description du fonctionnement ne va donc pas être répétée. Le comparateur 38 compare le signal issu de l'amplificateur intégrateur 25 à un seuil bas Vs- pour commander la fermeture d'un interrupteur 34, homologue de l'interrupteur 24, pour appliquer une tension continue de référence basse Vréf- à une troisième entrée du montage intégrateur comportant l'amplificateur 25, précisément à une extrémité d'une résistance 33 reliée, par son autre extrémité, à l'entrée inverseuse de l'amplificateur 25.

Le montage de la figure 3 pourrait aussi fonctionner avec une seule alimentation positive, entre la masse et 12 volts par exemple, la tension moyenne de 6 volts étant choisie comme valeur de repos en sortie de l'amplificateur intégrateur 25 et les tensions de seuil Vs+ et Vs-, de même que les tensions de référence Vréf+ et Vréf-, ayant de préférence des valeurs symétriques par rapport à cette valeur moyenne de 6 volts afin de disposer de deux plages de dynamiques les plus grandes possibles.

Cependant, il est ici prévu d'alimenter en positif, 12 volts, et en négatif, -12 volts, les circuits analogiques d'entrée (25) et au besoin les monostables 29, 39, dont les signaux logiques de sortie restent dans la plage des tensions positives.

De ce fait, c'est la masse qui représente la tension de repos et la tension de seuil Vs- est négative et égale, au signe près, à Vs +. Il en est de même pour Vréf- par rapport à Vréf+.

Les interrupteurs 24 et 34 sont alors du type inverseur repos/travail, avec une position de repos polarisant à la masse la résistance de l'entrée 23, 33 associée et évitant ainsi l'influence du bruit électronique.

Il est en outre prévu un interrupteur commutateur 31, en série entre la résistance 22 et la borne 4, commandé par le microprocesseur 12 pour effectuer un calibrage du zéro de dispositif de mesure, par mise à la masse de l'entrée de mesure 22.

Le fonctionnement du schéma de la figure 3 est le suivant.

Comme le montre la figure 4A, l'amplificateur intégrateur 25 fournit un signal croissant ou décroissant représentant l'intégrale du bilan de charge de la batterie 1, intégrale diminuée des effets des rétroactions ayant déjà eu lieu.

Les comparateurs 28, 38, dont les seuils VS + et Vs- encadrent la tension de repos de l'amplificateur-intégrateur 25, commandent, à travers les monostables respectifs 29 et 39 et les interrupteurs 24, 34, une rétroaction propre à chacun et ramenant la tension de sortie de l'amplificateur 25 dans la plage Vs- à Vs +.

Le monostable 29 commande ainsi les circuits 12-17, en aval, appartenant à la chaîne de mesure de l'intégrale N1 du courant de décharge et le monostable 39 commande de même une chaîne de mesure de l'intégrale N2 du courant de charge de la batterie 1, chaîne formée ici des mêmes circuits 12-17 que l'autre. Le circuit 13 calcule la différence N2-N1 entre le total N1 des impulsions Q + du monostable 29 et le total N2 des impulsions Q- du monostable 39 engendrées lorsque le seuil haut Vs+, respectivement bas Vs-, est franchi par sortie de la plage limitée par ces deux seuils N2-N1, représente la charge restante de la batterie 1.

Comme indiqué, l'interrupteur inverseur 31, qui équivaut à un court-circuit commandable du shunt d'entrée 21, permet au microprocesseur 11 de mesurer la pente de toute dérive parasite au cours du temps, par comptage des impulsions éventuelles d'un des comparateurs 28, 38 sur une durée déterminée, afin de corriger, numériquement de préférence dans le circuit 13, les valeurs ultérieures de mesure.

L'application d'un courant calibré entre les bornes 3, 4 permet le calibrage de la sensibilité de l'intégrateur d'entrée 22-27 et des circuits de rétroaction (partie analogique).

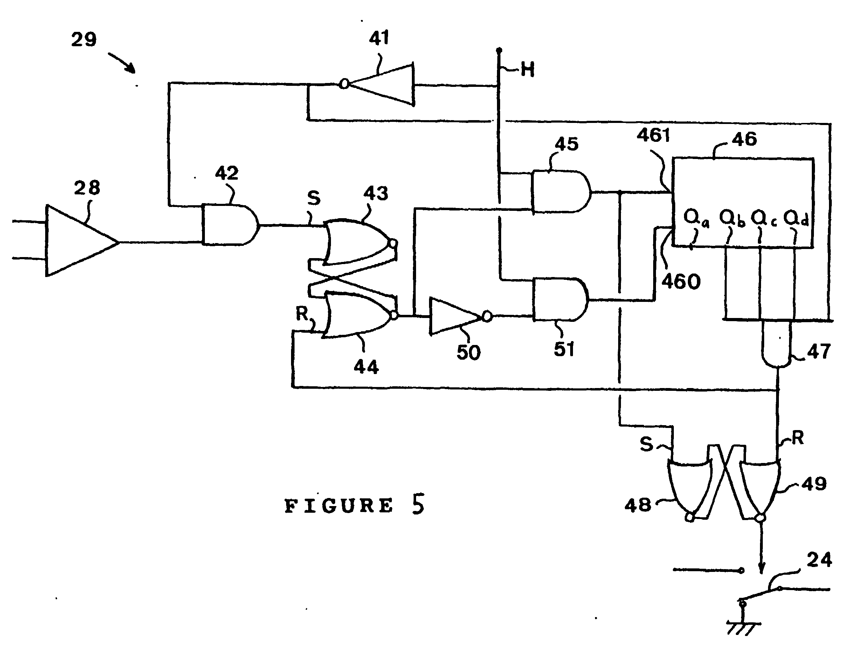

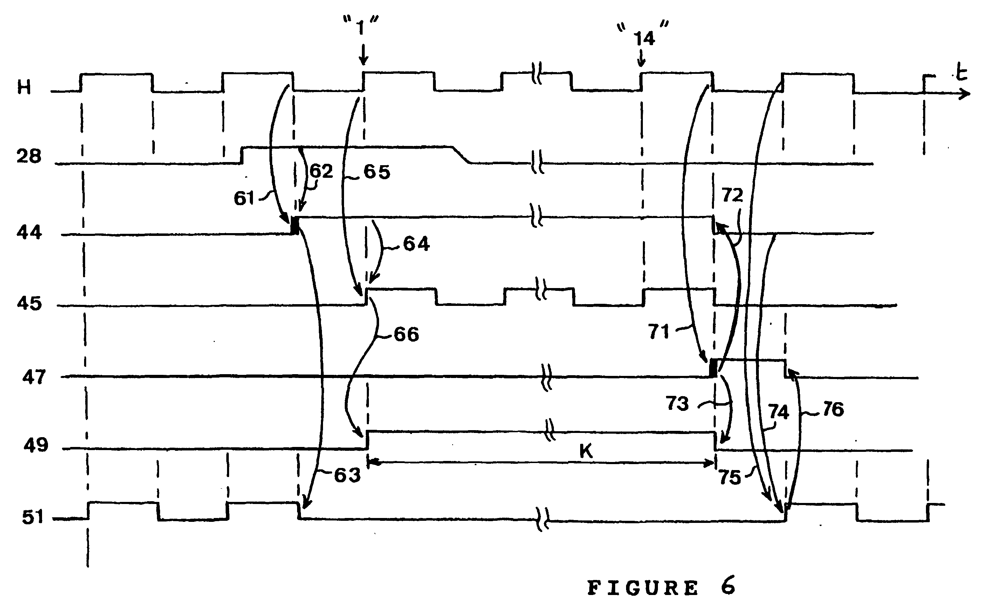

La figure 5 représente en détails le monostable, ou temporisateur numérique, 29, fournissant une impulsion de durée calibrée K, la figure 6 représentant, en fonction du temps t, l'état des sorties des éléments référencés.

Le temporisateur numérique 29 comporte un compteur synchrone 36 à quatre étages dont les sorties Qa, Qb, Qc, Qd commutent en synchronisme avec une horloge H de commande provenant de la base de temps 10 et, plus précisément, avancent, ou sont tous remis à zéro par une commande spéciale au moment du front montant de l'horloge H.

Afin d'éviter tout aléa de fonctionnement qui fausserait la durée K de la commande de l'interrupteur 24, le compteur 46 est entouré de diverses portes logiques qui permettent de le commander correctement, bien que le comparateur 28 ne présente aucun synchronisation par rapport à l'horloge H et que, par ailleurs, sa sortie repasse à l'état inactif avant la fin de la durée normale K de l'impulsion de commande de l'interrupteur 24.

A cet effet, la sortie du comparateur 28 est appliquée à une porte ET 42 d'échantillonnage, commandée par un signal d'horloge H inversé par un inverseur 41. La sortie de la porte 42 attaque l'entrée S d'armement d'une porte 43 d'une bascule asynchrone de type RS, formée de deux portes OU inverseuses 43, 44 rebouclées l'une sur l'autre. La sortie de la porte circuit OU inverseuse 44 est appliquée à l'entrée d'une porte ET 45 attaquant une entrée d'horloge 461 du compteur 46 et recevant le signal d'horloge H sur une seconde entrée. Dans cet exemple, on décode l'état "14" (et "15") du compteur 46 en reliant des sorties Qb, Qc, Qd à trois entrées d'une porte ET 47 à quatre entrées, recevant l'horloge H inversée sur la quatrième entrée.

La sortie de la porte ET 47 est reliée à l'entrée R de désarmement de la porte OU inverseuse 44 et à l'entrée R de désarmement d'une porte OU inverseuse d'une bascule asynchrone RS constituée de deux portes OU inverseuses 48, 49 mutuellement rebouclées et dont l'entrée S d'armement de la porte 48 est reliée à la sortie de la porte ET 45.

La sortie de la porte 49 commande l'interrupteur 24. Par ailleurs, une porte ET 51 reçoit l'horloge H et l'applique à une entrée 460 de remise à zéro du compteur 46 sous le contrôle d'une porte inverseuse 50 reliant la sortie de la porte OU inverseuse 44 à une entrée de la porte ET 51.

Le fonctionnement du temporisateur 29 est le suivant. A la mise sous tension, les deux bascules RS 43, 44 et 48, 49 sont forcées à l'état repos par activation en 1 de leur entrée R, par exemple par un circuit résistance série et condensateur parallèle en sortie de la porte ET 37, le condensateur effectuant un rappel temporaire vers la tension d'alimentation qui vient de s'établir. Le comparateur 28 étant au repos, à l'état logique 0 de sortie, la bascule RS 43, 44 conserve son état de repos, avec un état logique 0 en sortie qui ferme la porte ET 45 d'avance du compteur 46 et ouvre la porte ET 51 de remise à zéro à chaque coup d'horloge H. La porte ET 37 est donc fermée, de par l'état de sortie, tout en 0, du compteur 46 qui est bloqué.

Si le comparateur 28 fournit un état 1 d'activation du monostable 29, cet état 1 est échantillonné (flèche 62) par la porte 42 pendant la seconde demi-période du signal H au début de celle-ci sur la figure 5 : flèche 61, si l'on considère que le front montant, actif, correspond à un début de période. La bascule RS 43, 44 passe alors en 1 en sortie et déverrouille (flèche 64) la porte ET 45 d'avance du compteur 46 tout en verrouillant (flèche 63) la porte ET 51 de remise à zéro.

Ainsi, les commandes du compteur 46 sont prépositionnées à un instant quelconque mais uniquement dans la seconde demi-période d'horloge H si bien que le front actif montant de la période d'horloge H suivante, de passage à l'état 1 du compteur 46, est pris en compte dès qu'il arrive, donc sans tronquer la première période H de comptage, c'est-à-dire sans retarder l'activation de l'interrupteur 24. En d'autres termes, on fige l'environnement (42) de commande du compteur 46 lorsque celui-ci est susceptible d'avancer, afin qu'il ne reçoive pas des commandes contradictoires simultanées. L'activation de l'interrupteur 24 est commandée par la porte ET 45 d'activation du compteur 46, dont le premier front actif, montant, active en 1 (flèche 66) l'entrée S de la bascule 48, 49 et transmet cet état logique 1 en sortie 49 et l'y mémorise, ce qui active, par fermeture, l'interrupteur 24, de façon stable, sans transmettre l'horloge par la suite, au début de l'état de comptage 1.

Lorsque le compteur 46 parvient à l'état "14", les sorties Qb, Qc, Qd sont alors en 1, l'horloge H inversée de la porte ET 47 effectue un échantillonnage déphasé d'une demi-période par rapport à l'horloge H, c'est-à-dire ouvre (flèche 71) la porte ET 47 pendant la seconde demi-période de l'horloge H, alors que le compteur 46 a eu le temps de se stabiliser pendant la première demi-période. On évite ainsi tout décodage d'état transitoire, susceptible de remettre à zéro de façon anticipée le compteur 46.

L'état logique 1 en sortie de la porte ET 47 remet alors à zéro les bascules 43, 44 et 48, 49 (flèches 72, 73) en début de seconde demi-période de l'horloge H. L'interrupteur 24 est ainsi fermé pendant exactement 13,5 périodes de l'horloge H.

La porte 51 est déverrouillée (flèche 74) et laisse passer l'horloge H (flèche 65), qui remet à zéro le compteur 46 en début de période suivante. Ceci entraîne (flèche 66) la refermeture de la porte 47 de remise à zéro des bascules. Le monostable 29 peut à nouveau être déclenché par le comparateur 28.

## Revendications

1. Dispositif de mesure du courant échangé entre une source de stockage d'énergie (1) et des circuits électriques (19) d'un terminal portable de traitement de données ou de signaux, comportant un capteur de mesure de courant (21) destiné à être relié entre la source (1) et lesdits circuits (19), **caractérisé par le fait que** le capteur (21) est relié à une première entrée (22) de premiers moyens intégrateurs (22-27), agencés pour intégrer la mesure du courant et pour commander en conséquence des moyens comparateurs (28, 29, 34) agencés pour détecter le franchissement d'un seuil haut (Vs +) par l'intégrale du courant et pour alors appliquer, à une deuxième entrée (23) des premiers moyens intégrateurs (22-27), un signal de rétroaction calibré, de rappel en dessous du seuil haut (Vs+), et il est prévu des deuxièmes moyens intégrateurs (12-17), d'intégration des signaux de rétroaction, pour fournir une mesure du courant échangé.

2. Dispositif selon la revendication 1, dans lequel les moyens comparateurs (28, 29, 34) comportent, en sortie, des moyens (29, 34) de calibrage du signal de rétroaction, comportant un temporisateur (29) agencé pour fournir une impulsion de durée calibrée.

3. Dispositif selon la revendication 2, dans lequel les moyens de calibrage comportent un interrupteur (34) agencé pour être commandé par le temporisateur (29) et reliant une source, de tension prédéterminée, à la seconde entrée (23) des premiers moyens intégrateurs (22-27).

4. Dispositif selon l'une des revendications 1 à 3, dans lequel les deuxièmes moyens intégrateurs (12-17) sont, au moins en partie, solidaires de la source (1).

5. Dispositif selon l'une des revendications 1 à 4, dans lequel, pour la mesure d'un courant de sens opposé à celui tendant à activer les premiers moyens comparateurs (28, 29), il est prévu des seconds moyens comparateurs (38, 39) pour détecter le franchissement d'un seuil bas (Vs-) en sortie des premiers moyens intégrateurs (22-27) et pour appliquer en conséquence, à une troisième entrée (33) des premiers moyens intégrateurs (22-27), un signal de rétroaction calibré de rappel au-dessus du seuil bas (Vs-), des troisièmes moyens intégrateurs (12-17), d'intégration des signaux de rétroaction des seconds moyens comparateurs (28, 29) étant agencés pour fournir une mesure du courant considéré et il est prévu, aux sorties des deuxièmes et troisièmes moyens intégrateurs (12-17), des moyens (13) soustracteurs de leurs mesures respectives pour fournir une mesure de bilan de consommation.

6. Dispositif selon la revendication 5, dans lequel les premiers moyens intégrateurs (22-27) sont agencés pour fonctionner dans une plage limitée par les deux tensions de seuil, haut Vs + et bas Vs-, et centrée sur la masse.

7. Dispositif selon l'une des revendications 2 à 6, dans lequel le temporisateur (29) est numérique et comporte un compteur (46) de fourniture d'impulsions calibrées, commandé par un comparateur (28) à travers des circuits de synchronisation (41-45) agencés pour, en opposition de phase avec une horloge d'avance du compteur (46), échantillonner et mémoriser un état actif de sortie du comparateur (28).

8. Dispositif selon la revendication 7, dans lequel il est prévu des circuits (47 - 49, 44, 50, 51) d'échantillonnage de l'état du compteur (46), agencés pour, en opposition de phase avec l'horloge, détecter un état particulier du compteur (46) et remettre alors à un état de repos le compteur (46) et les circuits de synchronisation (41-45).

9. Terminal portable de traitement de données ou de signaux, **caractérisé par le fait qu'**il comporte un dispositif selon la revendication 1.

10. Terminal selon la revendication 9, dans lequel les deuxièmes moyens intégrateurs (12-17) sont agencés pour fournir différentes mesures de courant (15-17) en fonction de l'état de fonctionnement du terminal.

## Patentansprüche

1. Anordnung zur Messung des zwischen einer Energiespeicherquelle (1) und elektrischen Schaltungen (19) übertragenen Stroms für ein tragbares Endgerät zur Verarbeitung von Daten oder Signalen, die einen Strommeßfühler (21) umfaßt, der dazu bestimmt ist, zwischen der Quelle (1) und den besagten Schaltungen (19) angeordnet zu werden, **dadurch gekennzeichnet, daß** der Fühler (21) mit einem ersten Eingang (22) von ersten Integratormitteln (22-27) verbunden ist, die ausgebildet sind, um die Strommessung zu integrieren und entsprechend Komparatormittel (28, 29, 34) anzusteuern, die so ausgebildet sind, daß sie das Überschreiten eines oberen Schwellenwerts (Vs+) durch das Integral des Stroms erfassen und dann an einen zweiten Eingang (23) der ersten Integratormittel (22-27) ein kalibriertes Rückkopplungssignal zur Rückführung unterhalb des oberen Schwellenwerts (Vs+) anlegen, und daß zweite Integratormittel (12-17) und zur Integration der Rückkopplungssignale vorgesehen sind, um eine Messung des übertragenen Stroms zur Verfügung zu stellen.

2. Anordnung nach Anspruch 1, wobei die Komparatormittel (28, 29, 34) am Ausgang Mittel (29, 34) zur Kalibrierung des Rückkopplungssignals aufweisen, die einen Zeitgeber (29) umfassen, der eingerichtet ist, um einen Impuls einer kalibrierten Dauer zu liefern.

3. Anordnung nach Anspruch 2, wobei die Kalibiermittel einen Schalter (34) umfassen, der eingerichtet ist, um durch den Zeitgeber (29) angesteuert zu werden und eine Quelle einer vorgegebenen Spannung mit dem zweiten Eingang (23) der ersten Integratormittel (22-27) zu verbinden.

4. Anordnung nach einem der Ansprüche 1 bis 3, wobei die zweiten Integratormittel (12-17), zumindest teilweise, mit der Quelle (1) fest verbunden sind.

5. Anordnung nach einem der Ansprüche 1 bis 4, wobei für die Messung eines Stroms in entgegengesetzter Richtung zu demjenigen, der letztlich die ersten Komparatormittel (28, 29) aktiviert, zweite Komparatormittel (38, 39) vorgesehen sind, um das Überschreiten eines unteren Schwellenwerts (Vs-) am Ausgang der ersten Integratormittel (22-27) zu erfassen und um entsprechend an einen dritten Eingang (33) der ersten Integratormittel (22-27) ein kalibriertes Rückkopplungssignal zur Rückführung oberhalb des unteren Schwellenwerts (Vs-) anzulegen, und dritte Integratormittel (12-17) zur Integration von Rückkopplungssignalen der zweiten Komparatormittel (28, 29), die eingerichtet sind, um eine Messung des betrachteten Stroms zu liefern, und wobei an den Ausgängen der zweiten und dritten Integratormittel (12-17) Subtrahiermittel (13) für ihre jeweiligen Messungen vorgesehen sind, um eine Verbrauchsbilanzmessung zu liefern.

6. Anordnung nach Anspruch 5, wobei die ersten Integratormittel (22-27) eingerichtet sind, um in einem Bereich zu arbeiten, der durch die beiden Schwellenspannungen, die obere Vs+ und die untere Vs-, begrenzt wird und in Bezug auf Masse zentriert liegt.

7. Anordnung nach einem der Ansprüche 2 bis 6, wobei der Zeitgeber (29) digital ist und einen Zähler (46) zur Lieferung kalibrierter Impulse umfaßt, der durch einen Komparator (28) über Synchronisationsschaltungen (41-45) angesteuert wird, die eingerichtet sind, um in Gegenphase mit einem Taktgeber zum Vorwärtszählen des Zählers (46) einen aktiven Zustand des Ausgangs des Komparators (28) abzutasten und zu speichern.

8. Anordnung nach Anspruch 7, wobei Schaltungen (47-49, 44, 50, 51) zum Abtasten des Zustands des Zählers (46) vorgesehen sind, die ausgebildet sind, um in Gegenphase zu dem Taktgeber einen besonderen Zustand des Zählers (46) zu erfassen und den Zähler (46) und die Synchronisationsschaltungen (41-45) in einen Ruhezustand zurückzuführen.

9. Tragbares Endgerät zur Verarbeitung von Daten oder Signalen, **dadurch gekennzeichnet, daß** es eine Anordnung nach Anspruch 1 umfaßt.

10. Endgerät nach Anspruch 9, wobei die zweiten Integratormittel (12-17) ausgebildet sind, um abhängig von dem Betriebszustand des Endgeräts unterschiedliche Strommessungen (15-17), zu liefern.

## Claims

1. Device for measuring the current exchanged between a power/storage source (1) and electrical circuits (19) of a portable signals or data processing terminal, comprising a current measurement sensor (21) intended to be connected between the source (1) and said circuits (19), **characterised in that** the sensor (21) is connected to a first input (22) of first integrating means (22-27), arranged to integrate the measurement of the current and in order consequently to control comparator means (28, 29, 34) arranged to detect the clearing of a high threshold (Vs+) by the integral of the current and then to apply, at a second input (23) of the first integrating means (22-27), a calibrated retroaction signal, for return below the high threshold (Vs+), and second integrating means (12-17) are provided for integration of the retroaction signals to provide a measurement of the current exchanged.

2. Device according to Claim 1 whereby the comparator means (28, 29, 34) comprise, at the output, means (29, 34) of calibrating the retroaction signal, comprising a timer (29) arranged to supply a pulse of a calibrated duration.

3. Device according to Claim 2 whereby the calibration means comprise a switch (34) arranged to be controlled by the timer (29) and connecting a source of predetermined voltage to the second input (23) of the first integrating means (22-27).

4. Device according to one of the Claims 1 to 3 whereby the second integrating means (12-17) are, at least partly, integral with the source (1).

5. Device according to one of the Claims 1 to 4 whereby, for measuring a current in the direction opposite to that leading to activate the first comparator means (28, 29), second comparator means (38, 39) are provided to detect the clearing of a low threshold (Vs-) at the output of the first integrating means (22-27) and in order consequently to apply, at a third input (33) of the first integrating means (22-27), a calibrated retroaction signal for return above the low threshold (Vs-), third integrating means (12-17), for integration of the retroaction signals of the second comparator means (28, 29) being arranged to provide a measurement of the current in question and, at the outputs of the second and third integrating means (12-17), subtracting means (13) of their respective measurements to provide a consumption report measurement.

6. Device according to Claim 5 whereby the first integrating means (22-27) are arranged to operate in a range limited by the two threshold voltages, high Vs+ and low Vs-, and centred on the ground.

7. Device according to one of the Claims 2 to 6 whereby the timer (29) is digital and has a counter (46) for providing calibrated pulses, controlled by a comparator (28) through synchronisation circuits (41-45) arranged in order, in phase opposition with a clock for advancing the counter (46), to sample and memorise an active output state of the comparator (28).

8. Device according to Claim 7 whereby circuits (47-49, 44, 50, 51) are provided for sampling the state of the counter (46), arranged in order, in phase opposition with the clock, to detect a particular state of the counter (46) and then reset the counter (46) and the synchronisation circuits (41-45) to a rest condition.

9. Portable signals or data processing terminal, **characterised in that** it has a device according to Claim 1.

10. Terminal according to Claim 9 whereby the second integrating means (12-17) are arranged to provide different current measurements (15-17) in relation to the operating condition of the terminal.
